# EUROPÄISCHE PATENTANMELDUNG

(11) **EP 1 578 003 A1**
(43) Veröffentlichungstag der Anmeldung: **21.09.2005**
(21) Anmeldenummer: 04005467.8
(22) Anmeldetag: 08.03.2004
(51) Int. Cl.: H02K 3/50

(54) **Elektrische Maschine mit einer Vorrichtung zur Verschaltung von Leitungen des Wicklungssystems**

(71) Anmelder: SIEMENS AKTIENGESELLSCHAFT, 80333 München (DE)
(72) Erfinder: Eckert, Rainer, 97616 Bad Neustadt/Herschfeld (DE); Pawellek, Jürgen, 97618 Unsleben (DE)

(57) **Zusammenfassung**

Die Erfindung betrifft eine elektrische Maschine mit einem Stator (1) und zumindest einem Wicklungssystem (4) in einer Vielzahl von Nuten (2) des Stators (1) und einer Vorrichtung (7) zur Verschaltung von Leitungen des Wicklungssystems (4), wobei als Vorrichtung (7) zur Verschaltung von Leitungen zumindest eine flexible Leiterplatte vorgesehen ist, die an einer radialen Mantelfläche des Stators (1), das heißt auf dem Blechpaket (1a) oder auf der Außen- bzw. Innenseite der über das Blechpaket (1a) überstehenden Teile der radial angeordneten Polspulenträger (2) angebracht und mit den Leitungen des Wicklungssystems (4) verbindbar ist.

## Beschreibung

Die vorliegende Erfindung betrifft eine elektrische Maschine mit einer Vorrichtung zur Verschaltung von Leitungen des Wicklungssystems.

Elektrische Maschinen weisen im Stator zumindest ein Wicklungssystem auf, das beispielsweise in der so genannten Zahnspulen- oder Polspulentechnik ausgeführt ist. Dabei sind eine Vielzahl Polspulenträger, die jeweils eine Polspulenwicklung des Wicklungssystems beinhalten, in radial angeordneten Nuten eines sternförmig geformten Blechpakets des Stators eingebracht. Um die einzelnen Polspulenwicklungen miteinander zu verbinden, ist beispielsweise aus der DE 1930359 bekannt, eine Leiterplatte stirnseitig auf den Wickelkopf des Stators aufzubringen. Je nach Art des Wicklungssystems sind in der Leiterplatte dann entsprechende Durchführungen vorgesehen, durch die die Leitungsenden und -anfänge der einzelnen Polspulenwicklungen des Wicklungssystems durchgeführt und auf der Leiterplatte verlötet werden können.

Solch eine stirnseitige Anordnung der Leiterplatte hat aber unter anderem den Nachteil, dass die axiale Baulänge der elektrischen Maschine vergrößert wird. Zudem wird aufgrund der kreisrunden Bauform und der normalerweise üblichen Beschränkung des Durchmessers der Leiterplatte auf die radialen Abmessungen des Stators, das Layout der gedruckten Verschaltung auf der Leiterplatine bei zunehmender Anzahl von Polspulenwicklungen immer aufwendiger. Da sich die Leitungsenden bzw. -anfänge in axialer Richtung nicht ohne weiteres fixieren lassen, wird zudem die Montage der elektrischen Maschine aufwendiger und damit teurer.

Aufgabe der vorliegenden Erfindung ist deshalb, eine elektrische Maschine mit einer platzsparenden und einfach zu montierenden Vorrichtung zur Verschaltung von Leitungen des Wicklungssystems anzugeben.

Diese Aufgabe wird gelöst durch die elektrische Maschine mit den Merkmalen des Anspruchs 1, die einen Stator und zumindest ein Wicklungssystem in einer Vielzahl von Nuten des Stators und eine Vorrichtung zur Verschaltung von Leitungen des Wicklungssystems aufweist, wobei die Vorrichtung zur Verschaltung der Leitungen des Wicklungssystems zumindest eine flexible Leiterplatte ist, die an einer radialen Mantelfläche des Stators angebracht und mit den Leitungen verbindbar ist.

Dadurch, dass zumindest eine flexible Leiterplatte an einer der Mantelflächen des Stators angebracht wird, das heißt insbesondere an der äußeren und/oder der inneren radialen Mantelfläche des Blechpaktes des Stators oder an der äußeren und/oder der inneren radialen Mantelfläche der über das Blechpaket überstehenden Teile der radial angeordneten Polspulenträger des Stators, hat die erfindungsgemäße Anordnung im Gegensatz zu der aus dem Stand der Technik bekannten Anordnung den Vorteil, dass sie platzsparender ist, was letztendlich die notwendigen Abmessungen der gesamten elektrischen Maschine minimiert.

Weist die flexible Leiterplatte eine Vielzahl von Durchführungen wie beispielsweise Löcher und / oder Schlitze auf, die so angeordnet sind, dass vom Wicklungssystem radial wegstehende Leitungsanfänge und -enden der Leitungen des Wicklungssystems durch die Durchführungen führbar und mit diesen verlötbar sind, ist zudem eine einfache Montage der Vorrichtung zur Verschaltung der Leitungen und damit eine einfache Montage der elektrischen Maschine möglich. Das bedeutet, die flexible Leiterplatte kann in einfachster Weise an eine beliebige radiale Mantelfläche des Stators angebracht werden, indem beim Umwickeln der flexiblen Leiterplatte um die Mantelfläche des Stators gleichzeitig die radial wegstehenden Leitungsanfänge und -enden durch die Durchführungen geführt werden. Anschließend können diese Leitungsanfänge bzw. -enden dann in gewohnter Weise auf der flexiblen Leiterplatte verlötet und somit die einzelnen Polspulenwicklungen des Wicklungssystems miteinander verschaltet werden.

Alternativ oder zusätzlich kann die flexible Leiterplatte neben den Durchführungen auch eine Vielzahl von Lötpunkten aufweisen, die so angeordnet sind, dass vom Wicklungssystem radial wegstehende Leitungsanfänge und Leitungsenden der Leitungen mit diesen Lötpunkten verlötbar sind. So können insbesondere nach Anbringen der flexiblen Leiterplatte die Leitungsanfänge und -enden durch Umbiegen auf den entsprechenden Lötpunkten platziert werden und anschließend mit diesen verlötet werden. Auch diese Ausführung erlaubt im Gegensatz zu dem aus dem Stand der Technik Bekannten einen platzsparenderen Aufbau.

Leiterplatten als gedruckte Schaltungen und deren Ausführung auch in flexibler Ausbildung sind hinreichend bekannt und finden heute in vielen Bereichen der Technik Annwendung, so dass hier nicht weiter auf deren spezielle Eigenschaften eingegangen werden muss. Die Ausbildung der flexiblen Leiterplatte als Mehrlagen-Leiterplatte kann insbesondere dann vorteilhaft sein, wenn die elektrische Maschine eine geringe Baugröße und gleichzeitig eine Vielzahl von Polspulenwicklungen und damit eine Vielzahl von miteinander zu verschaltenden Leitungsanfängen und -enden aufweist. Die Mehrlagen-Leiterplatte ermöglicht auch auf geringstem Raum über mehrere so genannte Layer der Leiterplatte, die Leitungen des Wicklungssystems miteinander zu verbinden.

Zur elektrischen Isolation kann weiterhin zwischen dem Stator, das heißt insbesondere zwischen der Wicklung, den Polspulenträgern oder des Blechpakets, und der flexiblen Leiterplatte eine Schicht, wie beispielsweise eine Folie, aus einem elektrisch isolierenden Material angebracht werden. Entsprechend kann eine weitere Schicht zwischen dem Gehäuse der elektrischen Maschine und der flexiblen Leiterplatte vorgesehen werden.

Die Erfindung sowie ein mögliches Ausführungsbeispiel derselben werden im Weiteren anhand der nachfolgenden Figuren näher beschrieben. Es zeigen:
- Fig.1: ein Schnittbild durch einen Stator mit der erfindungsgemäßen Anordnung einer flexiblen Leiterplatte auf dem Außenmantel der über das Blechpaket überstehenden Teile der radial angeordneten Polspulenträger,
- Fig. 2: eine mögliche Ausführungsform der gedruckten Schaltung einer Mehrlagen-Leiterplatte für die Verschaltung der Leitungen des Wicklungssystems.

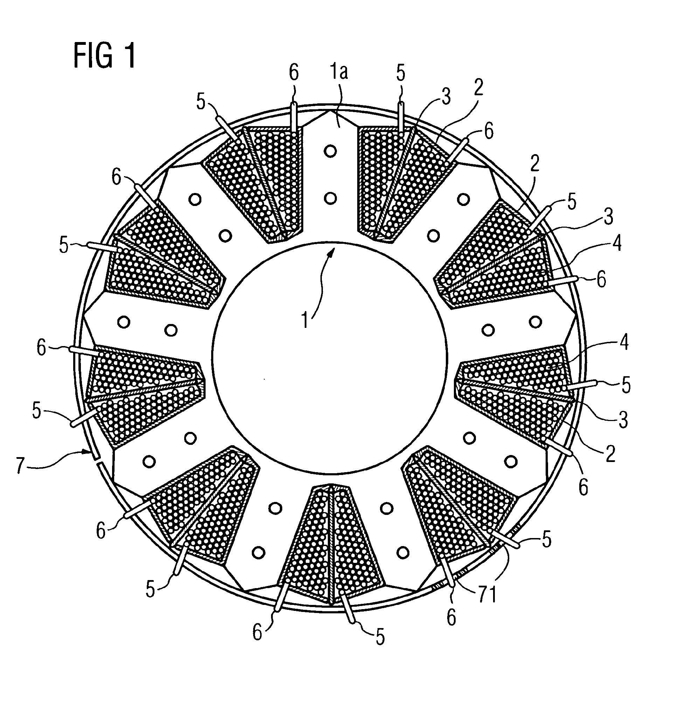

Figur 1 zeigt einen Stator 1, der in der so genannten Zahnspulentechnik bzw. Polspulentechnik ausgeführt ist. Im vorliegenden Ausführungsbeispiel ist der Stator 1 als so genanntes Sternpaket ausgebildet. Hier sind in den Nuten eines sternförmig ausgebildeten Blechpakets 1a jeweils zwei Polspulenträger 2, getrennt durch eine Phasentrennung 3, eingelegt. Jeder der Polspulenträger 2 beinhaltet eine Polspulenwicklung 4, also eine für die elektrische Maschine in geeigneter bekannter Weise aufgewickelte Leitung. Die über den Umfang des Stators 1 verteilten Polspulenwicklungen bilden zusammen das Wicklungssystem des Stators 1. Die Polspulenwicklungen 4 weisen Leitungsanfänge 5 und Leitungsenden 6 auf, die so miteinander verbunden werden müssen, dass die elektrische Maschine im Betrieb in geeigneter Weise elektrisch angeregt werden kann.

Erfindungsgemäß erfolgt diese Verbindung über eine flexible Leiterplatte 7, die an einer der Mantelflächen des Stators 1 angebracht wird. Eine Mantelfläche wird dabei gebildet durch die inneren oder äußeren Abmessungen des Blechpakets 1a oder durch die Außen- bzw. Innenabmessungen der über das Blechpaket überstehenden Teile der radial angeordneten Polspulenträger 2. Wie in dem in Figur 1 gezeigten Ausführungsbeispiel kann so die flexible Leiterplatte in einer radialen Ebene um bzw. auf den Außenmantel des Blechpakets 1a gewickelt werden. Alternativ oder zusätzlich kann eine flexible Leiterplatte auch auf die innere Mantelfläche, die sich auf der der Achse zugewandten Seite des Blechpakets 1a des Stators 1 befindet oder auch um die Außen- oder Innenseite der überstehenden Teile der radial angeordneten Polspulenträger 2 aufgebracht sein.

In einer bevorzugten Ausführungsform weist die, um die äußere Mantelfläche angebrachte flexible Leiterplatte 7 eine Anzahl von Durchführungen 71 auf, die so angeordnet sind, dass die von den einzelnen Polspulenwicklungen 4 des Wicklungssystems radial wegstehenden Leitungsanfänge 5 und Leitungsenden 6 beim Aufbringen der flexiblen Leiterplatte 7 durch die Durchführungen 71 führbar sind. Da die Leitungsenden 6 bzw. -anfänge 5 sich konstruktiv durch radiale Schlitze im Polspulenträger 2 in radialer Richtung genau positionieren lassen, lässt sich somit die flexible Leiterplatte 7 bei der Montage sehr einfach auf den Mantel des Sternpakets des Stators 1 aufrollen. Insbesondere kann somit die Montage weitgehend automatisiert erfolgen. Dadurch, dass die flexible Leiterplatte 7 direkt auf eine der Mantelflächen aufgebracht werden kann, ist zudem keine weiter zusätzliche Vorrichtung für die mechanische Fixierung der flexiblen Leiterplatte 7 in der elektrischen Maschine notwendig. Durch die erfindungsgemäße Ausführung werden so zudem Rüttel-, Schock- und Temperaturbelastungen minimiert.

Die flexible Leiterplatte 7 wird üblicherweise eine der Mantelfläche des Stators 1 entsprechende Form, also eine rechteckige Form aufweisen. So kann die ganze Fläche der flexiblen Leiterplatte 7 für die zur Verschaltung notwendige gedruckte Schaltung zur Verfügung stehen. Ist eine einfache überschneidungsfreie Anordnung der gedruckten Leiterbahnen auf der flexiblen Leiterplatte auf einem einzigen Layer nicht möglich oder zu aufwendig, so kann eine flexible so genannte Mehrlagen-Leiterplatte aus mehreren Layern verwendet werden.

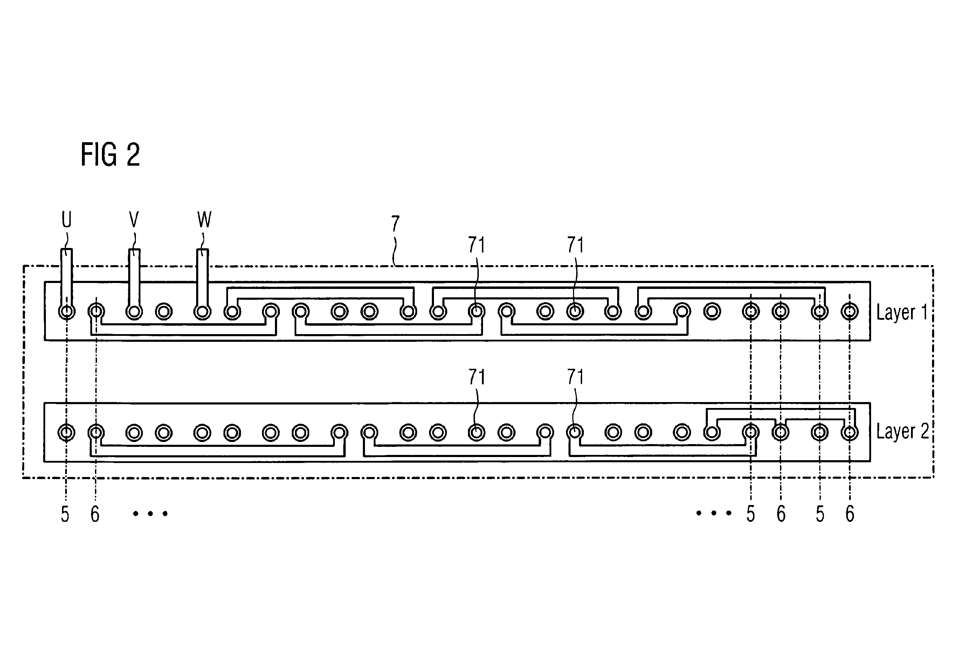

Figur 2 zeigt beispielhaft solch eine flexible Mehrlagen-Leiterplatte 7 mit in einer in zwei Layern (Layer 1 und Layer 2) gedruckten Schaltung. Die gedruckte Schaltung ist dabei vorzugsweise auf der Ober- und der Unterseite der flexiblen Leiterplatte 7 aufgebracht und weist eine Schaltstruktur auf, die zur sternförmigen Verschaltung der in Figur 1 gezeigten Anordnung der Polspulenwicklungen des Wicklungssystems 4 geeignet ist. Durch die Durchführungen 71 werden jeweils die entsprechenden Leitungsenden 6 bzw. -anfänge 5 der Polspulenwicklungen 4 geführt und anschließend mit der flexiblen Leiterplatte 1 verlötet. Die so miteinander verschalteten Polspulenwicklungen 4 werden über die entsprechende auf der Leiterplatte 7 gedruckte Struktur von Leitungen mit entsprechenden Zuleitungen U, V und, W für die einzelnen Stromphasen für die elektrische Erregung der elektrischen Maschine im Betrieb verbunden.

Die vorliegende Erfindung soll aber nicht auf die beschriebenen Ausführungsbeispiele beschränkt sein. So wird insbesondere auch dann noch ein platzsparender Aufbau erreicht, wenn auf der Leiterplatte 7 anstatt oder auch zusätzlich zu den Durchführungen 71 entsprechende Lötpunkte (nicht näher dargestellt) vorgesehen sind. Die Leitungsanfänge 5 und -enden 6 des Wicklungssystems müssen dann nach dem Aufbringen der flexiblen Leiterplatte 7 auf die Mantelfläche zuerst um die flexible Leiterplatte 7 herumgebogen werden, um sie dann auf die entsprechenden Lötpunkte der Leiterplatte 7 zu löten. Je nach Komplexität des Wicklungssystems und dem für die Leiterplatte 7 zur Verfügung stehenden Platzes kann zudem die Verwendung einer entsprechend komplexeren Mehrlagen-Leiterplatte 7 aus mehr als zwei Layern sinnvoll sein. Die Leitungsenden 6 und -anfänge 5 werden dabei in gleicher, wie zuvor beschriebener, Weise mit der flexiblen Leiterplatte 7 verbunden. Die einzelnen Layer der Leiterplatte sind durch entsprechend angeordnete Durchkontaktierungen untereinander verbunden, so dass sich eine komplexe dreidimensionale Schaltstruktur der flexiblen Mehrlagen-Leiterplatte ergibt.

## Patentansprüche

1. Elektrische Maschine mit einem Stator (1) und zumindest einem Wicklungssystem (4) in einer Vielzahl von Nuten (2) des Stators (1) und einer Vorrichtung (7) zur Verschaltung von Leitungen des Wicklungssystems,
**dadurch gekennzeichnet, dass**
die Vorrichtung (7) zur Verschaltung der Leitungen des Wicklungssystems (4) zumindest eine flexible Leiterplatte ist, die an einer radialen Mantelfläche des Stators (1) angebracht und mit den Leitungen verbindbar ist.

2. Elektrische Maschine nach Anspruch 1,
**dadurch gekennzeichnet, dass**
die flexible Leiterplatte (7) eine Vielzahl von Durchführungen (71) aufweist, die so angeordnet sind, dass vom Wicklungssystem (4) radial wegstehende Leitungsanfänge (5) und Leitungsenden (6) der Leitungen durch diese Durchführungen (71) führbar und mit diesen verlötbar sind.

3. Elektrische Maschine nach Anspruch 1 oder 2,
**dadurch gekennzeichnet, dass**
die Durchführungen als Loch und/oder als Schlitz ausgebildet sind.

4. Elektrische Maschine nach Anspruch 1 bis 3,
**dadurch gekennzeichnet, dass**
die flexible Leiterplatte (7) eine Vielzahl von Lötpunkten aufweist, die so angeordnet sind, dass vom Wicklungssystem (4) radial wegstehende Leitungsanfänge (5) und Leitungsenden (6) der Leitungen mit diesen Lötpunkten verlötbar sind.

5. Elektrische Maschine nach einem der Ansprüche 1 bis 4,
**dadurch gekennzeichnet, dass**
zumindest eine flexible Leiterplatte (7) eine Mehrlagen-Leiterplatte ist.

6. Elektrische Maschine nach einem der Ansprüche 1 bis 5,
**dadurch gekennzeichnet, dass**
zumindest eine flexible Leiterplatte (7) an der äußeren radialen Mantelfläche und/oder der inneren radialen Mantelfläche des Blechpakets (1a) des Stators (1) angebracht ist.

7. Elektrische Maschine nach einem der Ansprüche 1 bis 5,
**dadurch gekennzeichnet, dass**
zumindest eine flexible Leiterplatte (7) an der äußeren radialen Mantelfläche und/oder der inneren radialen Mantelfläche der über das Blechpaket (la) überstehenden Teile der radial angeordneten Polspulenträger (2) des Stators (1) angebracht ist.

8. Elektrische Maschine nach einem der vorherigen Ansprüche 1 bis 7,
**dadurch gekennzeichnet, dass**
zwischen der radialen Mantelfläche des Stators (1) und der flexiblen Leiterplatte (7) ein zumindest elektrisch isolierendes Material angebracht ist.

9. Elektrische Maschine nach einem der Ansprüche 1 bis 8,
**dadurch gekennzeichnet, dass**
auf der, dem Stator (1) abgewandten Seite der flexiblen Leiterplatte (7) ein zumindest elektrisch isolierendes Material angebracht ist.

10. Elektrische Maschine nach einem der vorherigen Ansprüche 1 bis 9,
**dadurch gekennzeichnet, dass**
der Stator (1) in Zahnspulentechnik ausgebildet ist.
